**Europäisches Patentamt**

(19) **European Patent Office**

**Office européen des brevets**

(11) Numéro de publication: **0 076 193**
**B1**

(12) ## FASCICULE DE BREVET EUROPEEN

(45) Date de publication du fascicule du brevet:
10.04.85

(51) Int. Cl.⁴: **G 01 R 31/30**

(21) Numéro de dépôt: **82401684.4**

(22) Date de dépôt: **16.09.82**

(54) **Procédé pour déterminer le seuil de résistance d'un équipement électrique ou électronique à une agression électromagnétique extérieure et dispositifs pour sa mise en oeuvre.**

(30) Priorité: **29.09.81 FR 8118306**

(43) Date de publication de la demande:
**06.04.83 Bulletin 83/14**

(45) Mention de la délivrance du brevet:
**10.04.85 Bulletin 85/15**

(84) Etats contractants désignés:
**BE CH DE IT LI NL SE**

(56) Documents cités:
**ELEKTROTECHNIK, vol.63, no.3, 16 février 1981,
Würzburg (DE), J. STROHE: "Sicher gegen Störungen",
pages 24-27
PROCEEDINGS ON THE IEEE, vol. 66, no. 4, avril 1978,
New York (US) E.E. DONALDSON et al.: "Field
measurements made in an enclosure", pages 464-472
PROCEEDINGS OF THE IEEE 1980 NATIONAL
AEROSPACE AND ELECTRONICS CONFERENCE,
Naecon 1980, vol. 2, 1980, IEEE, New York (US) D.G. FOX
et al.: "Lightning threat definition for aircraft electrical
power systems", pages 562-577
IEEE TRANSACTIONS ON NUCLEAR SCIENCE, vol.
NS-27, no. 6, décembre 1980, New York (US) D.F.
HIGGINS et al.: "SGEMP leakage through satellite cable
shields: The importance of transfer admittance coupling
and its implications on testing", pages 1589-1595**

(73) Titulaire: **Société Nationale Industrielle Aérospatiale
Société anonyme dite:, 37 Bld de Montmorency,
F-75016 Paris (FR)**

(72) Inventeur: **Crochet, Michel Henri, 13 Allée des
Chevreuils, F-78840 Verneuil sur Seine (FR)**
Inventeur: **Riaudet, Jean-Claude Louis Léon, 58 rue
Maurice Braunsten, F-78200 Mantes-la-Jolie (FR)**

(74) Mandataire: **Bonnetat, Christian et al, Cabinet PROPI
Conseils 23 rue de Léningrad, F-75008 Paris (FR)**

## Description

La présente invention concerne un procédé pour déterminer le seuil de résistance d'un équipement électrique ou électronique à une agression électromagnétique extérieure, ainsi que des dispositifs pour la mise en œuvre de ce procédé.

On sait que dans de nombreuses installations techniques modernes fixes ou mobiles sont utilisés des équipements électriques ou électroniques sensibles aux perturbations électromagnétiques. Dans le cas où se produirait une explosion nucléaire, une impulsion électromagnétique très intense serait engendrée et cette impulsion serait susceptible d'influer sur lesdits équipements, jusqu'à les rendre inopérants. En effet, une telle impulsion électromagnétique se propage comme une onde plane transportant une certaine énergie; avant d'arriver sur les équipements vulnérables, une partie de l'énergie est absorbée par divers écrans, par exemple structuraux, qui sont interposés sur son trajet et qui ont pour effet d'atténuer l'amplitude des champs électromagnétiques. Néanmoins, une certaine énergie reste disponible au niveau des câblages de liaison et des équipements et, par couplage direct (rayonnement) ou indirect (courants conduits et canalisés par la structure des installations), des courants éventuellement intenses peuvent circuler sur les blindages et les surblindages des câblages reliant les équipements entre eux et engendrer ainsi sur certaines entrées des équipements des tensions parasites gênantes, voire dangereuse pour leur fonctionnement.

A la fabrication des équipements, on peut déterminer aisément soit par l'analyse théorique des circuits, soit par l'expérience, les niveaux parasites électromagnétiques admissibles sur les entrées desdits équipements.

En revanche, au stade de l'intégration de ces matériels et de leur interconnexion, il est indispensable de vérifier expérimentalement le bon fonctionnement de l'ensemble, d'une part en ambiance normale, dite saine, d'autre part en ambiance perturbée.

Les essais en ambiance saine ayant pour but de contrôler le bon état fonctionnel de l'ensemble, les essais en ambiance perturbée ont pour rôle de s'assurer qu'aucune fonction n'est altérée lorsqu'on expose volontairement l'ensemble à une agression électromagnétique simulée.

En règle générale, toutes dispositions de construction et de connexion étant prises pour que les équipements puissent résister à une agression électromagnétique donnée, les essais en ambiance perturbée confirment que tous les équipements et leurs périphériques fonctionnent correctement, même dans les conditions de l'agression.

Cependant, il est intéressant de connaître avec quelle marge le bon fonctionnement est assuré, d'autant que l'environnement des équipements à contrôler (vibrations, échauffement, corrosion, etc.) peut occasionner des faiblesses passagères ou durables du matériel.

Il est donc d'un intérêt essentiel de vérifier, dans des conditions réelles d'utilisation (équipements reliés entre eux et dialoguant par leurs câblages d'interconnexion), où se situe le seuil de fonctionnement incorrect, lorsque des dégradations localisées et quantifiées des liaisons permettent d'appliquer sur les entrées des équipements des niveaux de perturbation connus.

On connaît déjà des procédés pour tester la résistance d'équipements électriques ou électroniques à une agression par application de tensions parasites en des emplacements déterminés de ceux-ci. Cependant, aucun de ces procédés connus ne permet d'appliquer des tensions déterminées à l'entrée d'un équipement:

a) sans le déconnecter de ses périphériques,

b) en superposition sur ses signaux fonctionnels,

c) en environnement électromagnétique perturbé, du type explosion nucléaire.

Ces procédés connus ne permettent, au mieux, que de satisfaire à deux de ces trois conditions a, b et c.

Par exemple, on connaît déjà des circuits d'injection se branchant à l'entrée d'un dispositif électrique ou électronique et permettant d'injecter des parasites connus. De tels circuits d'injection permettent de déterminer la marge de fonctionnement du dispositif testé, mais, en revanche, nécessitent que celui-ci soit débranché de ses périphériques, puisque lesdits circuits prennent leur place. On ne peut alors tester que le dispositif pris isolément et non l'équipement dans son ensemble.

Dans une variante, on intercale dans les liaisons entre les dispositifs de l'équipement au moins un circuit d'injection et au moins un circuit de mesure, afin de ne pas interrompre lesdites liaisons. Un tel procédé est extrêmement limité dans ses conditions d'utilisation, puisqu'il suppose que le signal mesuré par le circuit de mesure présente les mêmes caractéristiques que le signal réel à l'entrée de l'équipement, ce qui est faux. En effet, le fait d'adjoindre les circuits d'injection et de mesure à l'équipement introduit des capacités parasites qui faussent la détermination précise du seuil de bon fonctionnement.

Par ailleurs, on a déjà proposé de soumettre l'ensemble de l'équipement à une irradiation directe, grâce à un générateur électromagnétique [voir, par exemple, Proceedings of the IEEE, vol. 66, N° 4, avril 1978, New York (US), E.E. Donaldson *et al.*, "Field measurements made in an enclosure", pp. 464-472]. Cependant, une telle méthode n'autorise pas la détermination expérimentale du seuil de bon fonctionnement du fait que les niveaux de rayonnement requis exigeraient une dynamique impossible à obtenir avec les générateurs actuellement connus. De plus, cette méthode ne permet pas de déterminer la valeur du niveau de parasite à l'entrée de l'équipement ayant occasionné la défaillance.

La présente invention a pour objet de remédier à ces inconvénients. Elle permet de déterminer de manière simple et significative le seuil et la marge de bon fonctionnement par insertion de parasites et sans nécessité de mesurer la tension parasite injectée. De plus, elle répond aux trois conditions a, b et c mentionnées ci-dessus.

A cette fin, selon l'invention, le procédé pour déterminer le seuil de résistance d'un équipement électrique ou électronique à une agression extérieure électromagnétique par simulation de cette agression, ledit équipement comportant au moins deux unités reliées entre elles par une liaison comportant des conducteurs entourés par un blindage, est remarquable en ce que l'on intercale dans ladite liaison au moins un élément d'injection présentant une impédance de transfert connue et comportant une enveloppe extérieure, des conducteurs intérieurs et des connecteurs d'extrémité, de sorte que ledit élément d'injection assure la continuité des liaisons électriques normales entre lesdites unités et que son enveloppe extérieure soit électriquement reliée au blindage de ladite liaison, en ce que l'on soumet ledit équipement pourvu de son élément d'injection à l'action d'un champ électromagnétique de test, en ce qu'on intervient sur ledit élément et/ou sur ledit champ pour perturber le fonctionnement dudit équipement et en ce qu'on détermine ledit seuil à partir de l'impédance de transfert dudit élément d'injection lorsque survient la première perturbation du fonctionnement de l'équipement.

Ainsi, le seuil de résistance à une agression extérieure électromagnétique correspond à une valeur de l'amplitude de l'agression électromagnétique en deçà de laquelle le fonctionnement dudit équipement reste normal et au-delà de laquelle ce fonctionnement est perturbé et éventuellement inhibé.

Par ailleurs, on sait que l'impédance de transfert d'un élément est le rapport ZT de la tension apparaissant, sous l'action du champ électromagnétique extérieur, entre conducteurs réunis à une extrémité de l'enveloppe et l'autre extrémité de l'enveloppe, et du courant parcourant ladite enveloppe. Un avantage essentiel de la présente invention réside en ce que, le courant parcourant l'enveloppe pouvant être mesuré facilement de l'extérieur par un système à tore ferromagnétique par exemple, aucune mesure de tension n'est nécessaire à l'intérieur de l'enveloppe.

Selon un mode d'éxécution de la présente invention, on peut intercaler un élément d'injection d'impédance de transfert connue dans la liaison et faire varier le champ électromagnétique extérieur; on peut même intercaler successivement des éléments d'injection d'impédance de transfert croissante et simultanément faire varier le champ électromagnétique. Cependant, comme on l'a mentionné ci-dessus, les générateurs connus actuels de champ électromagnétique ne présentent pas une dynamique très grande. Aussi, malgré le fait que l'interposition d'un élément selon l'invention permet de diminuer la dynamique requise du générateur, selon un procédé de mise en œuvre préféré de l'invention, on maintient constante l'amplitude du champ électromagnétique de test et on intercale successivement dans ladite liaison des éléments d'injection d'impédance de transfert croissante, l'impédance de transfert d'au moins le premier élément mis en place étant choisi à priori telle que la tension engendrée à l'intérieur de l'enveloppe par le champ électromagnétique de test soit sans action sur le fonctionnement de l'équipement; on note l'impédance de transfert du dernier élément d'injection pour lequel le fonctionnement de l'équipement n'est pas perturbé et/ou l'impédance de transfert du premier élément d'injection pour lequel le fonctionnement de l'équipement devient perturbé, et, à partir de l'impédance de transfert de l'un de ces éléments, on détermine ledit seuil.

Ce procédé de mise en œuvre de l'invention est basé sur le fait qu'augmenter successivement l'impédance de transfert des éléments coaxiaux est équivalent à augmenter l'amplitude du champ électromagnétique. En effet, pour un champ d'amplitude R (par exemple en kilovolts/mètre), le blindage est parcouru par un courant I qui est une fonction de R, de sorte qu'une tension $V = ZT \times I$ apparaît à l'intérieur du blindage. Une augmentation $\Delta R$ de l'amplitude de champ R entraînerait donc un accroissement $\Delta I$ du courant I et un accroissement $\Delta V$ de la tension V, et l'on pourrait écrire

$$\frac{\Delta R}{R} = \frac{\Delta I}{I} = \frac{\Delta V}{V}$$

Maintenant, si R est maintenu constant, il en est de même de I et la tension V prend la valeur $V = ZT \times I$. Si on augmente l'impédance de transfert ZT de la quantité $\Delta ZT$, la tension V augmente de $\Delta V = \Delta ZT \times I$. Par suite, le rapport $\frac{\Delta ZT}{ZT}$ est égal à $\frac{\Delta V}{V}$. La variation d'impédance de transfert est donc équivalente à une variation de champ électromagnétique et la marge de bon fonctionnement, qui devrait être mesurée par $\frac{\Delta R}{R}$, peut donc être représentée par $\frac{\Delta V}{V}$.

Selon le mode de mise en œuvre préféré de l'invention, le champ électromagnétique est maintenu constant à la valeur R et on intercale des éléments d'impédance de transfert ZT1, ZT2, ZT3, ... ZTn1, ZTn, ZTn + 1 croissante. Les éléments d'impédance ZT1, ZT2, ... ZTn n'apportent pas de perturbation au fonctionnement de l'équipement. En revanche, lorsque l'élément d'impédance ZTn + 1 est en place, ce fonctionnement est perturbé. Par ailleurs, en l'absence de ces éléments coaxiaux, la liaison dans laquelle ceux-ci sont intercalés présente sa propre impédance de transfert ZTo, avec

ZTo < ZT1 < ZT2 < ... < ZTn−1 < ZTn < ZTn+1

Par suite, la marge de bon fonctionnement est déterminée par

$$\frac{\Delta V}{V} = \frac{\Delta ZT}{ZTo} = \frac{ZTn - ZTo}{ZTo}$$

Du fait que $\dfrac{\Delta R}{R} = \dfrac{\Delta V}{V}$, on peut déterminer $\Delta R$, qui

est égal à $\Delta R = \dfrac{ZTn - ZTo}{ZTo} \times R$

Il en résulte que le seuil de bon fonctionnement est

$$R + \Delta R = R\left[1 + \frac{ZTn - ZTo}{ZTo}\right], \text{ soit}$$

$$R + \Delta R = R\frac{ZTn}{ZTo}$$

Si l'on désire connaître $V$, $\Delta V$ et $V + \Delta V$, il suffit de mesurer les courants $I$ et $I + \Delta I$ parcourant respectivement le blindage de la liaison et ceux de la liaison et de l'élément coaxial, au moyen d'un dispositif à tore ou analogue.

Le dispositif pour la mise en œuvre du procédé selon l'invention comporte une enveloppe tubulaire formant blindage et entourant les conducteurs destinés à assurer les liaisons électriques, ainsi que des connecteurs auxquels sont reliés ces conducteurs, lesdits connecteurs étant pourvus de moyens de connexion isolés desdits conducteurs, mais en contact électrique avec ladite enveloppe. Ces moyens de connexion peuvent comprendre des bagues ou des écrous filetés.

Ladite enveloppe tubulaire peut par exemple être constituée par tronçons de tube d'une matière résistante et conductrice, d'un enroulement hélicoïdal d'un fil, d'une gaine métallique tressée, etc.

Pour la mise en œuvre du procédé préféré selon l'invention, on dispose d'un jeu comportant une pluralité de tels éléments, étalonnés selon leur impédance de transfert. Un tel étalonnage peut être obtenu en soumettant les éléments à un champ électromagnétique connu et en mesurant le courant parcourant leur enveloppe.

On voit ainsi que la présente invention permet d'estimer une marge de bon fonctionnement ou de déterminer le point faible d'une chaîne d'équipements, lorsque tous ces équipements dialoguent entre eux. Elle intervient donc au niveau final d'une intégration en permettant par injection locale d'un courant externe ou par rayonnement sur tout l'ensemble de qualifier une chaîne complète, d'en déceler les points faibles et de situer le seuil d'apparition des premières défaillances.

Les figures du dessin annexé feront bien comprendre comment l'invention peut être réalisée:

la fig. 1 donne à titre d'exemple non limitatif le schéma synoptique d'un équipement électronique,

la fig. 2 illustre la mise en œuvre du procédé selon l'invention à l'équipement montré par la fig. 1,

la fig. 3 est une vue en élévation d'un dispositif pour la mise en œuvre du procédé selon l'invention,

la fig. 4 est une coupe selon la ligne IV-IV de la fig. 3.

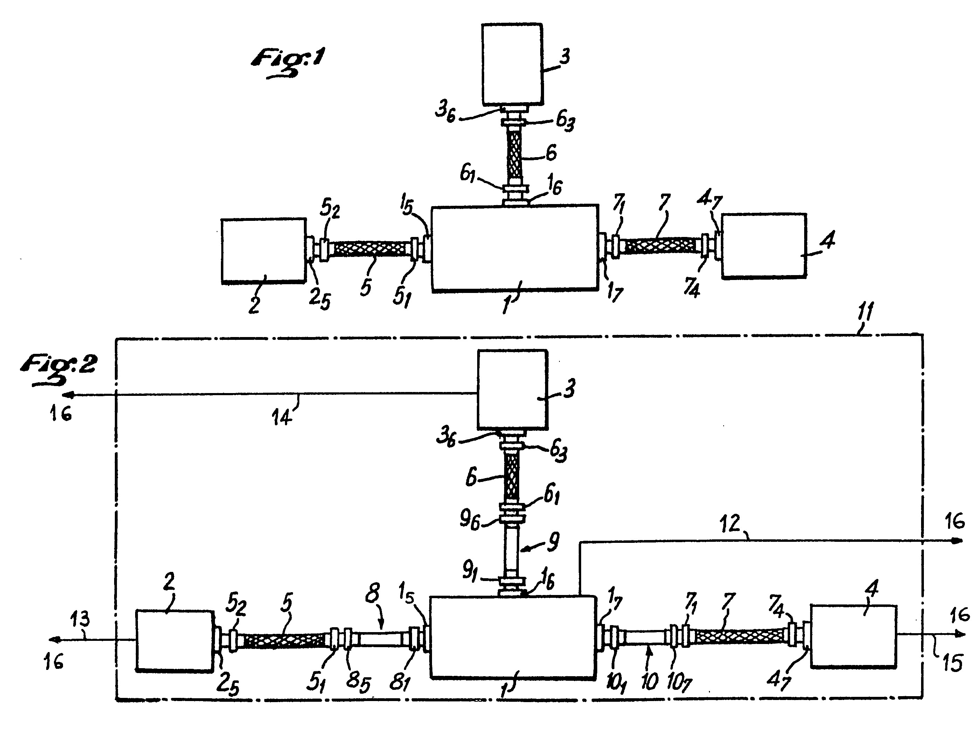

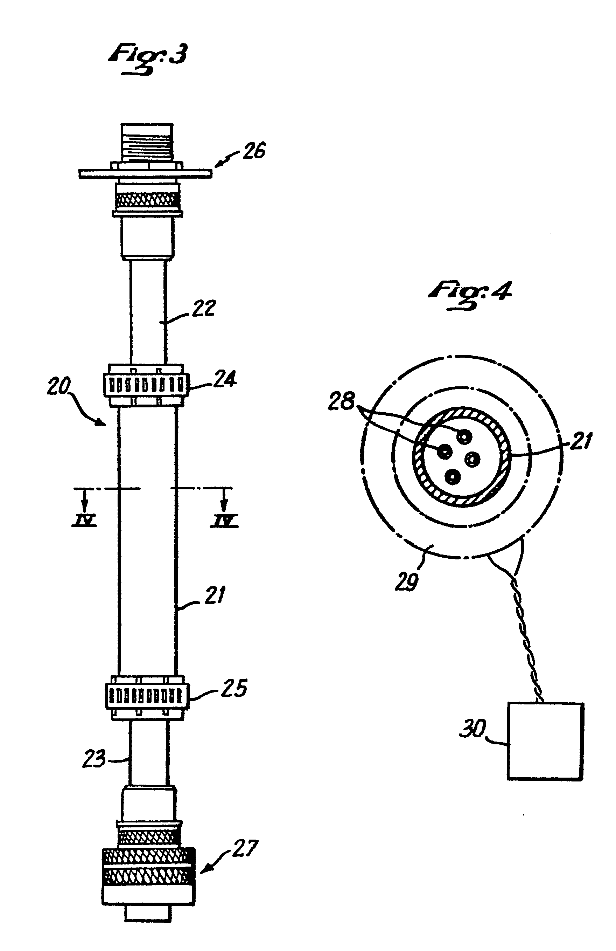

Sur la fig. 1, on a représenté un exemple arbitraire d'équipement électronique comportant un dispositif principal 1 et trois dispositifs périphériques 2, 3 et 4. Les dispositifs périphériques 2, 3 et 4 sont reliés au dispositif principal 1 par l'intermédiaire de câbles d'interconnexion 5, 6 et 7. A cet effet, les dispositifs 1 à 4 sont respectivement pourvus de connecteurs $1_5$, $1_6$, $1_7$, $2_5$, $3_6$ et $4_7$, respectivement prévus pour coopérer avec les connecteurs complémentaires $5_1$, $6_1$, $7_1$, $5_2$, $6_3$ et $7_4$ des câbles 5, 6, et 7. Sur les fig. 1 et 2, chacun des connecteurs porte la référence du dispositif 1 à 4 ou du câble 5 à 7 duquel il est solidaire, affectée d'un indice correspondant à la référence du dispositif 1 à 4 ou du câble 5 à 7 auquel il est destiné à être relié.

Ainsi, les dispositifs 1 à 4 sont interconnectés et dialoguent entre eux. Leurs conceptions, ainsi que les liaisons effectuées par les câbles 5, 6 et 7, sont telles que l'ensemble 1 à 7 est susceptible de fonctionner normalement, lorsqu'il est soumis au champ d'un rayonnement électromagnétique normalisé R (par exemple exprimé en kilovolts/mètre et simulant une explosion nucléaire).

Le problème que l'on résout grâce à l'invention est de déterminer le seuil de bon fonctionnement, c'est-à-dire, si l'on pouvait augmenter la puissance rayonnée à laquelle est soumis l'ensemble 1 à 7, déterminer le champ $R + \Delta R$ à partir duquel les premières défaillances de fonctionnement apparaissent.

Comme il n'est guère possible techniquement de faire varier et d'augmenter le champ R auquel on peut soumettre l'ensemble 1 à 7, on met en œuvre le procédé de l'invention, illustré par la fig. 2.

Selon ce procédé de l'invention, on intercale dans au moins certaines des liaisons entre le dispositif 1 et les dispositifs 2, 3 et 4 des éléments d'injection 8, 9 et 10 présentant chacun une impédance de transfert connue et permettant la continuité des liaisons de fonctionnement normal entre ces dispositifs. On possède une pluralité d'éléments 8, 9 et 10 (portant la référence générale 20 sur les fig. 3 et 4) étalonnés en impédance de transfert.

Ainsi, on dispose l'ensemble 1 à 4 dans une enceinte ou espace 11 à l'intérieur de laquelle ou duquel on peut engendrer le champ électromagnétique R. On met en place les éléments 8, 9 et 10. A cet effet, ceux-ci sont pourvus de connecteurs $8_1$, $9_1$, $10_1$, susceptibles de coopérer avec les connecteurs $1_2$, $1_6$, et $1_7$, et de connecteurs $8_5$, $9_6$ et $10_7$, susceptibles de coopérer avec les connecteurs $5_1$, $6_1$ et $7_1$. On soumet alors l'ensemble 1 à 10 au champ R et, grâce à des liaisons 12 à 15 et à un dispositif de contrôle 16 (non représenté et extérieur à l'enceinte 11), on vérifie le fonctionnement de l'ensemble 1 à 10. A des fins de simplification, on suppose que l'impédance de transfert des éléments 8, 9 et 10 est la même et égale à ZT1 pendant le premier essai. Si le dispositif de contrôle 16 indique que, dans ces conditions, le fonctionnement du dispositif 1 à 7 est correct, on remplace les éléments 8, 9 et 10 par d'autres, présentant une impédance de transfert égale à ZT2, avec ZT2 < ZT1. Et ainsi de suite, jusqu'à ce que le dispositif de contrôle 16 indique la première défaillance de l'équipement 1 à 7.

On a donné ci-dessus les calculs permettant de déterminer le seuil de bon fonctionnement.

La structure d'un mode de réalisation 20 des éléments 8, 9 et 10 est illustrée par les fig. 3 et 4. Ces éléments étant insérés dans les liaisons normales entre le dispositif principal 1 et les dispositifs périphériques 2, 3 et 4, il est indispensable que les connecteurs $8_1$, $9_1$ et $10_1$ soient semblables respectivement aux connecteurs $5_1$, $6_1$ et $7_1$, tandis qu'il faut que les connecteurs $8_5$, $9_6$ et $10_7$ soient semblables respectivement aux connecteurs $1_5$, $1_6$ et $1_7$. Dans le mode de réalisation 20, les connecteurs $8_1$, $9_1$ et $10_1$ sont représentés par une embase multibroche 26, tandis que les connecteurs $8_5$, $9_6$ et $10_7$ sont figurés par une prise mobile 27. Par ailleurs, l'élément 20 doit assurer la transmission de l'information entre chaque broche du connecteur ($1_5$, $1_6$ ou $1_7$) de l'équipement 1 et chaque broche du connecteur ($5_1$, $6_1$ ou $7_1$) du câble 5, 6 ou 7. Il en résulte qu'il existe un câblage fil à fil entre les connecteurs 26 et 27, grâce à une pluralité de conducteurs 28.

L'élément 20 comporte une partie centrale creuse 21, à l'intérieur de laquelle passent les conducteurs 28, et dont les caractéristiques électriques et physiques (conductivité, impédance de transfert, dimensions, etc.) sont choisies en fonction des caractéristiques de l'équipement 1, 2, 3 et 4.

Les connecteurs 26 et 27 sont reliés à la partie centrale creuse 21 par deux pièces métalliques d'adaptation 22 et 23, respectivement, assurant le contact électrique. La fixation des pièces d'adaptation 22 et 23 sur la partie centrale 21 s'effectue grâce à des moyens de serrage respectivement 24 et 25. Cette fixation pourrait également être obtenue par soudure. De même, la fixation des connecteurs 26 et 27 sur les pièces d'adaptation 22 et 23 peut être réalisée par soudure, ou éventuellement par vissage.

Les caractéristiques électriques souhaitées pour chaque élément 20 sont obtenues en choisissant de façon adéquate la partie centrale 21. Celle-ci peut être, entre autres:

a) Un tube résistant, par exemple à base de carbone, ne présentant pas de self-inductance. Grâce à la conductivité assez moyenne du carbone, il est aisé d'obtenir des valeurs de résistance relativement élevées (de 1 à 5000 $\Omega$) en conservant à l'élément 20 des dimensions raisonnables. De plus, dans ce cas, l'impédance étant purement résistive, la détermination de la tension induite V à l'intérieur de la résistance tubulaire s'effectue simplement en appliquant la loi d'ohm généralisée:

$V = ZT \times I$, I étant le courant parcourant extérieurement la résistance tubulaire sous l'action du champ R.

b) Un tube métallique, par exemple en cuivre, pourvu d'une pluralité de trous le long des génératrices du tube. Les diamètres et/ou le nombre des trous permettent d'ajuster l'impédance de transfert, par exemple de 10 à 100 m$\Omega$.

c) Un bobinage hélicoïdal d'un fil résistant. Un tel bobinage permet de couvrir aisément une gamme d'impédances comprise entre 100 m$\Omega$ et 10$\Omega$. Cette impédance peut ne pas être constante en fréquence, la détermination de la tension induite V nécessitant alors des calculs mathématiques, à base de transformation de Fourier par exemple.

d) Une gaine métallique tressée, en cuivre étamé par exemple. Dans ce cas, les lacunes de recouvrement des différents fuseaux et des différentes nappes ont également pour conséquence que l'impédance de transfert n'est pas constante en fonction de la fréquence. Grâce à une telle gaine, on peut obtenir une gamme d'impédances comprise entre 1 m$\Omega$ et 1$\Omega$.

Notamment lorsque l'impédance de la partie centrale 21 est purement résistive, il est aisé de la mesurer et donc d'étalonner l'élément 20 correspondant. Pour cela, comme illustré sur la fig. 4, il suffit, lorsque l'élément 20 est soumis à un champ R (par exemple dans l'enceinte 11), de mesurer i) le courant I circulant dans la partie centrale 21 au moyen d'un appareil de mesure ampèremétrique comportant un tore 29 entourant cette partie centrale et un ampèremètre 30, et ii) la tension V entre un conducteur 28 et la masse (au moyen d'un voltmètre non représenté). L'impédance ZT s'obtient alors en faisant le rapport $\frac{V}{I}$. Cette impédance ZT étant maintenant connue, il est facile de connaître (lors de la mise en œuvre du procédé selon l'invention illustré par la fig. 2), la tension V induite à l'intérieur de la partie centrale 21. Il suffit de mesurer le courant I au moyen de l'appareil 29, 30. De la mesure de I et de la valeur de ZT, on déduit la tension V par la relation $V = ZT \times I$.

**Revendications**

1. Procédé pour déterminer le seuil de résistance d'un équipement électrique ou électronique à une agression extérieure électromagnétique par simulation de cette agression, ledit équipement comportant au moins deux unités (1 à 4) reliées entre elles par une liaison (5 à 7) comportant des conducteurs entourés par un blindage, caractérisé en ce que l'on intercale dans ladite liaison (5 à 7) au moins un élément d'injection (8 à 10) présentant une impédance de transfert connue et comportant une enveloppe extérieure (21), des conducteurs intérieurs (28) et des connecteurs d'extrémité (26, 27), de sorte que ledit élément d'injection assure la continuité des liaisons électriques normales entre lesdites unités et que son enveloppe extérieure soit électriquement reliée au blindage de ladite liaison, en ce que l'on soumet ledit équipement pourvu de son élément d'injection à l'action d'un champ électromagnétique de test, en ce qu'on intervient sur ledit élément et/ou sur ledit champ pour perturber le fonctionnement dudit équipement et en ce qu'on détermine ledit seuil à partir de l'impédance de transfert dudit élément d'injection (8 à 10) lorsque survient la première perturbation du fonctionnement de l'équipement (1 à 4).

2. Procédé selon la revendication 1, caractérisé en ce qu'on intercale un élément d'injection d'impédance de transfert connue dans la liaison et on fait varier le champ électromagnétique extérieur.

3. Procédé selon la revendication 1, caractérisé en ce qu'on intercale successivement des éléments d'injection d'impédance de transfert croissante et simultanément on fait varier le champ électromagnétique.

4. Procédé selon la revendication 1, caractérisé en ce qu'on maintient constante l'amplitude du champ électromagnétique de test et on intercale successivement dans ladite liaison des éléments d'injection d'impédance de transfert croissante, l'impédance de transfert d'au moins le premier élément mis en place étant choisie à priori telle que la tension engendrée à l'intérieur de l'enveloppe par le champ électromagnétique de test soit sans action sur le fonctionnement de l'équipement, on note l'impédance de transfert du dernier élément d'injection pour lequel le fonctionnement de l'équipement n'est pas perturbé et/ou l'impédance de transfert du premier élément d'injection pour lequel le fonctionnement de l'équipement devient perturbé, et, à partir de l'impédance de transfert de l'un de ces éléments, on détermine ledit seuil.

5. Dispositif pour la mise en œuvre du procédé spécifié sous l'une des revendications 1 à 4, caractérisé en ce qu'il comporte une enveloppe tubulaire formant blindage et entourant les conducteurs (28) destinés à assurer les liaisons électriques, ainsi que des connecteurs (26, 27) auxquels sont reliés ces conducteurs, lesdits connecteurs étant pourvus de moyens de connexion isolés desdits conducteurs, mais en contact électrique avec ladite enveloppe.

6. Dispositif selon la revendication 5, caractérisé en ce que son enveloppe est constituée d'un tronçon de tube électriquement conducteur.

7. Dispositif selon la revendication 5, caractérisé en ce que son enveloppe est constituée par enroulement et/ou tressage de fils.

8. Ensemble de dispositifs pour la mise en œuvre du procédé de l'une des revendications 3 ou 4, caractérisé en ce qu'il est constitué d'une pluralité de dispositifs des revendications 5 et 6 présentant des impédances de transfert différentes étalonnées.

**Patentansprüche**

1. Verfahren zum Bestimmen der Widerstandsschwelle elektrischer oder elektronischer Anlagen auf ein von aussen kommendes Eindringen elektromagnetischer Energie durch Simulieren des Eindringens, wobei die Anlage zumindest zwei Einheiten (1 bis 4) aufweist, die über einen Anschluss (5 bis 7) miteinander verbunden sind, der Leiter aufweist, die von einer Abschirmung umgeben sind, dadurch gekennzeichnet, dass in den Anschluss (5 bis 7) zumindest ein Einspeisungselement (8 bis 10) zwischengeschaltet wird, das eine bekannte Übertragungsimpedanz hat und einen Aussenmantel (21), Innenleiter (28) und Endleiter (26, 27) aufweist, so dass das Einspeisungselement die Kontinuität der normalen elektrischen Verbindung zwischen den Einheiten gewährleistet, und dass ein Aussenmantel an die Abschirmung des Anschlusses angeschlossen ist, dass die Anlage, die mit dem Einspeisungselement versehen ist, der Wirkung eines elektromagnetischen Prüffeldes ausgesetzt wird, dass auf das Element und/oder das Feld ein Eingriff vorgenommen wird, um den Betrieb der Anlage zu stören, und dass ausgehend von der Übertragungsimpedanz des Einspeisungselements (8 bis 10) die Schwelle bestimmt wird, während die erste Betriebsstörung der Anlage (1 bis 4) auftritt.

2. Verfahren nach Anspruch 1, dadurch gekennzeichnet, dass ein Einspeisungselement mit bekannter Übertragungsimpedanz in die Verbindung zwischengeschaltet und das äussere elektromagnetische Feld variiert wird.

3. Verfahren nach Anspruch 1, dadurch gekennzeichnet, dass aufeinanderfolgend Einspeisungselemente steigender Übertragungsimpedanz zwischengeschaltet werden und das elektromagnetische Feld gleichzeitig variiert wird.

4. Verfahren nach Anspruch 1, dadurch gekennzeichnet, dass die Amplitude des elektromagnetischen Prüffeldes konstant gehalten wird und aufeinanderfolgend in die Verbindung Einspeisungselemente steigender Übertragungsimpedanz zwischengeschaltet werden, wobei die Übertragungsimpedanz von zumindest dem ersten eingesetzten Element *a priori* derart gewählt ist, dass die im Innern des Mantels von dem elektromagnetischen Prüffeld erzeugte Spannung auf den Betrieb der Anlage ohne Wirkung bleibt, die Übertragungsimpedanz des letzten Einspeisungselements, bei der der Betrieb der Anlage nicht gestört wird und/oder die Übertragungsimpedanz des ersten Einspeisungselements, bei der der Betrieb der Anlage gestört wird, vermerkt wird und ausgehend von der Übertragungsimpedanz eines dieser Elemente die Schwelle bestimmt wird.

5. Vorrichtung zur Durchführung des in den Ansprüchen 1 bis 4 beanspruchten Verfahrens, dadurch gekennzeichnet, dass sie eine Abschirmung bildenden Mantel, der die Leiter (28) umgibt, die die elektrische Verbindung sichern, und Anschlüsse (26, 27), an denen diese Leiter liegen, aufweist, wobei die Anschlüsse mit von den Leitern isolierten Anschlussmitteln versehen sind, die jedoch mit dem Mantel elektrischen Kontakt haben.

6. Vorrichtung nach Anspruch 5, dadurch gekennzeichnet, dass der Mantel aus einem elektrisch leitenden Rohrabschnitt besteht.

7. Vorrichtung nach Anspruch 5, dadurch gekennzeichnet, dass der Mantel aus Drahtumwicklungen und/oder Drahtgeflecht besteht.

8. Vorrichtungsanordnung zur Durchführung des Verfahrens nach einem der Ansprüche 3 oder 4, dadurch gekennzeichnet, dass sie mehrere Vorrichtungen der Ansprüche 5 und 6 aufweist, in denen die Übertragungsimpedanzen verschieden kalibriert sind.

## Claims

1. Method to determine the threshold of resistance of an electric or electronic equipment to an external electromagnetic aggression by simulating such aggression, said equipment comprising at least two units (1 to 4) joined together by a connection (5 to 7) comprising screened conductors, characterized in that at least one injection element (8 to 10) is inserted in said connection (5 to 7), which element has a known transfer impedance and comprises an external casing (21), inner conductors (28), and end conductors (26, 27), so that said injection element ensures a continuity of the normal electric connections between the said units, and that its external casing is electrically connected to the screening of said connection, that said equipment equipped with its injection element is subjected to the action of an electromagnetic testing field, that said element and/or said field is acted upon to disturb the operation of the said equipment and that said threshold is determined from the transfer impedance of said injection element (8 to 10) when a first disturbance occurs in the operation of the equipment (1 to 4).

2. Method as claimed in Claim 1, characterized in that an injection element of known transfer impedance is inserted in the connection and the external electromagnetic field is caused to vary.

3. Method as claimed in Claim 1, characterized in that successive injection elements of increasing transfer impedance are inserted and the electromagnetic field is caused to vary simultaneously.

4. Method as claimed in Claim 1, characterized in that the amplitude of the electromagnetic resting field is kept constant and injection elements of increasing transfer impedance are successively inserted in the said connection, the transfer impedance of at least the first element in position being *a priori* selected so that the voltage generated inside the casing by the electromagnetic testing field has no action on the operation of the equipment, a note is made of the transfer impedance of the last injection element at which the operation of the equipment is not disturbed and/or of the transfer impedance of the first injection element at which the operation of the equipment starts to become disturbed, and from the transfer impedance of one of these elements is determined the threshold.

5. Device for carrying out the method claimed in one of Claims 1 to 4, characterized in that said device comprises a tubular screening casing enclosing the conductors (28) designed to ensure the electrical connections, as well as connectors (26, 27) to which are connected said conductors, which connectors are provided with connection means insulated from the said conductors but in electrical contact with said casing.

6. Device as claimed in Claim 5, characterized in that said casing is constituted by a section of electrically conducting tube.

7. Device as claimed in Claim 5, characterized in that said casing is constituted by a coil and/or braid of wires.

8. Assembly of devices for carrying out the method claimed in Claim 3 or 4, characterized in that said assembly is constituted by a plurality of devices such as claimed in Claims 5 and 6, presenting different calibrated transfer impedance.

Fig:1

Fig:2

Fig. 3

Fig. 4